# EUROPEAN PATENT APPLICATION

(11) **EP 1 342 808 A1**
(43) Date of publication of application: **10.09.2003**
(21) Application number: 03075554.0
(22) Date of filing: 26.02.2003
(51) Int. Cl.: C23C 14/24, H01L 21/82, H01L 21/84

(54) **Elongated thermal physical vapor deposition source with plural apertures for making an organic light-emitting device**

(30) Priority: 08.03.2002 US 93739
(71) Applicant: EASTMAN KODAK COMPANY, Rochester, New York 14650 (US)
(72) Inventor: Freeman, Dennis Ray, c/o Eastman Kodak Company, Rochester, New York 14650-2201 (US); Redden, Neil, c/o Eastman Kodak Company, Rochester, New York 14650-2201 (US); Van Slyke, Steven A., c/o Eastman Kodak Company, Rochester, New York 14650-2201 (US)
(74) Representative: Weber, Etienne Nicolas

(57) **Abstract**

An elongated thermal physical vapor deposition source for vaporizing organic materials in forming an OLED on a structure includes an elongated container for receiving vaporizable organic material, and an elongated vaporization heater sealingly disposed over the container. The vaporization heater includes a plurality of vapor efflux apertures formed along an elongated direction of the heater, and arranged to provide improved uniformity of vapor efflux of vaporized organic material along the elongated direction of the source.

## Description

The present invention relates generally to vapor deposition of an organic layer onto a structure which will form part of an organic light-emitting device (OLED).

An organic light-emitting device, also referred to as an organic electroluminescent device, can be constructed by sandwiching two or more organic layers between first and second electrodes.

In a passive matrix organic light-emitting device (OLED) of conventional construction, a plurality of laterally spaced light-transmissive anodes, for example indium-tin-oxide (ITO) anodes, are formed as first electrodes on a light-transmissive substrate such as, for example, a glass substrate. Two or more organic layers are then formed successively by vapor deposition of respective organic materials from respective sources, within a chamber held at reduced pressure, typically less than 10⁻³ torr (1.33 x 10⁻¹ pascal). A plurality of laterally spaced cathodes is deposited as second electrodes over an uppermost one of the organic layers. The cathodes are oriented at an angle, typically at a right angle, with respect to the anodes.

Applying an electrical potential (also referred to as a drive voltage) operates such conventional passive matrix organic light-emitting devices between appropriate columns (anodes) and, sequentially, each row (cathode). When a cathode is biased negatively with respect to an anode, light is emitted from a pixel defined by an overlap area of the cathode and the anode, and emitted light reaches an observer through the anode and the substrate.

In an active matrix organic light-emitting device (OLED), an array of anodes are provided as first electrodes by thin-film transistors (TFTs) which are connected to a respective light-transmissive portion. Two or more organic layers are formed successively by vapor deposition in a manner substantially equivalent to the construction of the aforementioned passive matrix device. A common cathode is deposited as a second electrode over an uppermost one of the organic layers. The construction and function of an active matrix organic light-emitting device is described in US-A-5,550,066, the disclosure of which is herein incorporated by reference.

Organic materials, thicknesses of vapor-deposited organic layers, and layer configurations, useful in constructing an organic light-emitting device, are described, for example, in US-A-4,356,429, US-A-4,539,507, US-A-4,720,432, and US-A-4,769,292, the disclosures of which are herein incorporated by reference.

A source for thermal physical vapor deposition of organic layers onto a structure for making an organic light-emitting device has been disclosed by Robert G. Spahn in commonly assigned US-A-6,237,529, issued May 29, 2001. The source disclosed by Spahn includes a housing, which defines an enclosure for receiving solid organic material, which can be vaporized. The housing is further defined by a top plate which defines a vapor efflux slit-aperture for permitting vaporized organic materials to pass through the slit onto a surface of a structure. The housing defining the enclosure is connected to the top plate. The source disclosed by Spahn further includes a conductive baffle member attached to the top plate. This baffle member provides line-of-sight covering of the slit in the top plate so that vaporized organic material can pass around the baffle member and through the slit onto the substrate or structure while particles of organic materials are prevented from passing through the slit by the baffle member when an electrical potential is applied to the housing to cause heat to be applied to the solid organic material in the enclosure causing the solid organic material to vaporize.

In using the thermal physical vapor deposition source disclosed by Spahn to form an organic layer of a selected organic material on a substrate or structure, it has been found that the vapor efflux slit-aperture causes nonuniform vapor flux of organic material vapor to emanate along a length dimension of the slit. While the technical or physical aspects of source design related to this nonuniformity of vapor flux are not fully understood at present, it appears that opposing edges of the slit-aperture, that is, edges opposed in a width direction of the slit, sag or rise nonuniformly over a central portion of the slit when the source is heated to cause vaporization of solid organic material. This is a particular problem when a width dimension of the slit is reduced, for example, to a width dimension less than 0.5 millimeter (mm). Such spatially nonuniform orientation of opposing slit edges can be thought of as a deviation of planarity of opposing edges which, in turn, can promote a greater fraction of vaporized organic material to exit the vapor deposition source through a central portion of the slit, with a correspondingly lower fraction of vaporized organic material exiting the source through remaining portions of the slit along its length dimension. Such nonuniform vapor flux, directed at a substrate or structure, will cause the formation of an organic layer thereon which will have a nonuniform layer thickness in correspondence with the nonuniform vapor flux.

It is an object of the present invention to provide an elongated thermal physical vapor deposition source for forming organic layers on a structure which will form part of an organic light-emitting device (OLED).

This object is achieved in a method for coating a structure by vaporizing organic material disposed in an elongated container having walls, comprising the steps of:
a) providing a cover on the container having apertures;
b) providing a baffle between the cover and the organic material to prevent direct access of vaporized organic material from passing through the apertures without first engaging the walls of the container; and
c) forming the apertures to have varying size or varying spacing between adjacent apertures, or combinations thereof, wherein such varying aperture size or varying aperture spacing is selected to provide a substantially improved uniformity of vapor efflux of vaporized organic material along the elongated direction of a vapor deposition source so that the vaporized organic material is prevented by the baffle from direct line-of-sight access to the apertures to prevent particulate organic material from passing through the apertures.

This object is further achieved by an elongated thermal physical vapor deposition source for vaporizing solid organic materials and applying a vaporized organic material as a layer onto a surface of a structure in a chamber at reduced pressure in forming a part of an organic light-emitting device (OLED), comprising:
a) an elongated electrically insulative container for receiving solid organic material which can be vaporized, the container defined by side walls having common upper side wall surfaces, and a bottom wall;
b) an elongated vaporization heater sealingly disposed on the common upper side wall surfaces of the container, the vaporization heater defining a plurality of vapor efflux apertures extending into the container and arranged along an elongated direction of the vaporization heater, such apertures having varying size or varying spacing between adjacent apertures, or combinations thereof, wherein such varying aperture size or varying aperture spacing is selected to provide a substantially improved uniformity of vapor efflux of vaporized organic material along the elongated direction of the vapor deposition source when the vaporization heater is heated to vaporize a portion of the solid organic material in the container;
c) an elongated electrically conductive baffle member electrically connected to the vaporization heater, the baffle member being spaced from the vaporization heater in a direction towards the container, the baffle member substantially providing a line-of-sight covering of the plurality of vapor efflux apertures to prevent direct access of vaporized organic materials to the apertures, and to prevent particulate organic materials from passing through the apertures;
d) means for applying an electrical potential to the vaporization heater to cause vaporization heat to be applied to uppermost portions of the solid organic material in the container causing such uppermost portions to vaporize so that vaporized organic material is projected off the side walls of the container and lower surfaces of the vaporization heater and an upper surface of the baffle member through the plurality of vapor efflux apertures onto the structure to provide an organic layer on the structure; and
e) means for providing relative motion between the elongated vapor deposition source and the structure in directions substantially perpendicular to the elongated direction of the source to provide a substantially uniform organic layer on the structure.

### ADVANTAGES

An advantage of the present invention is that the spacings between adjacent ones of the plurality of vapor efflux apertures in the elongated vaporization heater permit a selection of varying aperture sizes or aperture spacings, or combinations thereof, to provide a substantially improved uniformity of vapor efflux of vaporized organic material along the elongated direction of the vapor deposition source when heat causes vaporization of solid organic material received in the container.

Another advantage of the present invention is that spacings between adjacent ones of the plurality of vapor efflux apertures in the elongated vaporization heater provide mechanical stability to the apertures so that opposing aperture edges retain planarity when the vaporization heater is heated to cause vaporization of solid organic material received in the container.

Relative motion is provided between the elongated vapor deposition source and the structure in directions substantially perpendicular to the elongated direction of the source to aid in providing a substantially uniform organic layer on the structure.
FIG. 1 is a schematic perspective view of a passive matrix organic light-emitting device having partially peeled-back elements to reveal various layers;
FIG. 2 is a schematic perspective view of an OLED apparatus suitable for making a relatively large number of organic light-emitting devices (OLEDs) and having a plurality of stations extending from hubs;
FIG. 3 is a schematic section view of a carrier containing a relatively large number of substrates or structures, and positioned in a load station of the apparatus of FIG. 2 as indicated by section lines 3-3 in FIG. 2;
FIG. 4 is a schematic perspective view of an elongated thermal physical vapor deposition source in accordance with the present invention;
FIG. 5 is a schematic perspective view of an elongated electrically insulative container, which is included in the vapor deposition source of FIG. 4;
FIG. 6 is a schematic sectional view of the vapor deposition source of FIG. 4 taken along the elongated direction as indicated by section lines 6-6 in FIG. 4, and showing a baffle member, electrical leads connected to the vaporization heater, a heat-reflective coating on exterior surfaces of the container, and a solid organic material in powdery form received in the container;
FIG. 7 is a schematic sectional view of the vapor deposition source of FIG. 4 taken perpendicular to the elongated direction as indicated by section lines 7-7 in FIG. 4;
FIG. 8 is a sectional view similar to the view of FIG. 6 and showing solid organic material in the form of solid pellets received in the container;
FIG. 9 is a sectional view similar to the view of FIG. 7 and showing a solid pellet of organic material in the container;
FIG. 10 is a schematic perspective view of another embodiment of an elongated thermal physical vapor deposition source in accordance with the present invention in which an elongated container is disposed in an elongated bias heater, and an elongated vaporization heater is sealingly disposed over the container;
FIG. 11 is a schematic sectional view of the vapor deposition source of FIG. 10 taken perpendicular to the elongated direction as indicated by section lines 11-11 in FIG. 10;
FIGS. 12A-12H are schematic plan views of an elongated vaporization heater having a plurality of spaced vapor efflux apertures arranged with respect to a center line which extends along an elongated direction of the vaporization heater in accordance with the present invention, wherein

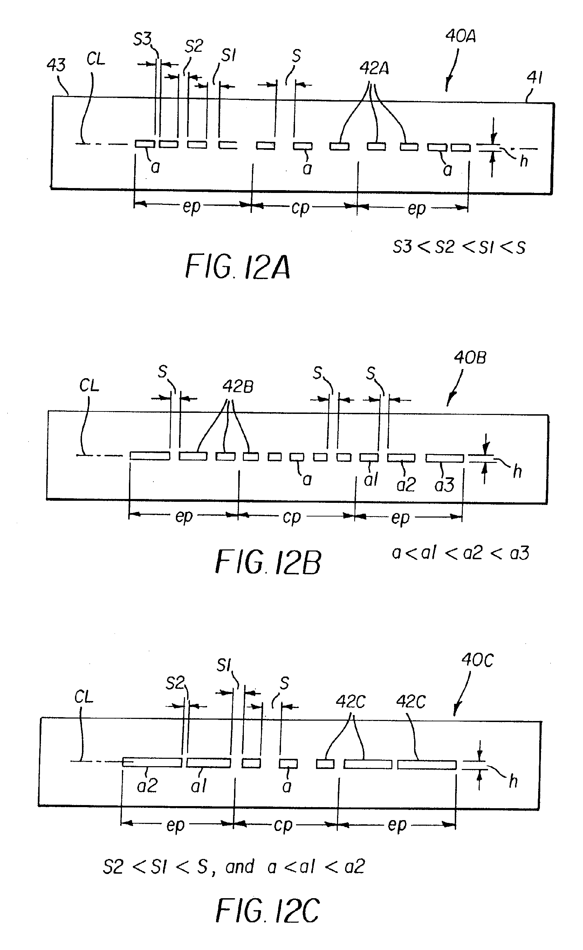

FIG. 12A depicts a plurality of apertures of a selected constant apertures size or aperture area, and a decreasing spacing between apertures at end portions of the aperture arrangement;
FIG. 12B shows a plurality of apertures having a selected constant spacing between adjacent apertures and an increasing aperture size or aperture area at end portions of the aperture arrangement;
FIG. 12C indicates a plurality of apertures with apertures at end portions of the aperture arrangement having an increasing aperture area and a decreasing aperture spacing;

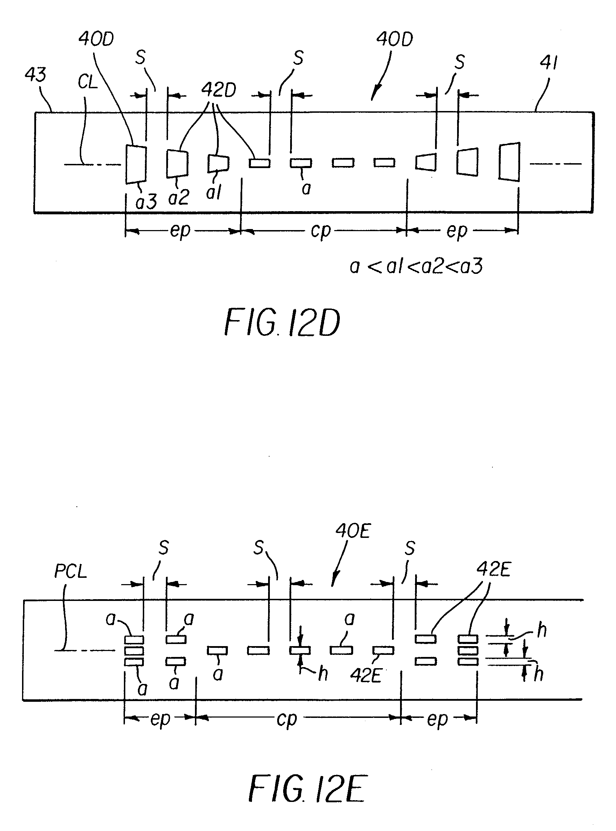

FIG. 12D depicts a plurality of apertures having a selected constant spacing between adjacent apertures and an increasing aperture area at end portions of the aperture arrangement, with apertures at the end portions showing a trapezoidal outline and apertures in a central portion showing a rectangular outline;
FIG. 12E indicates a plurality of apertures having a selected constant aperture area and a selected constant spacing between adjacent apertures along the elongated direction, and providing parallel rows of apertures at end portions of the aperture arrangement;

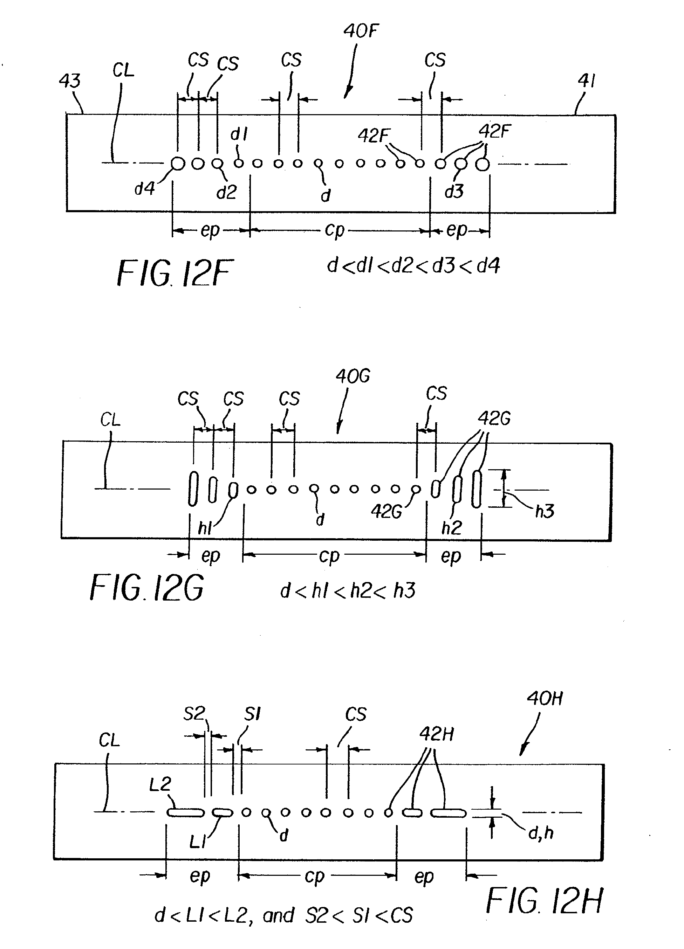

FIG. 12F shows a plurality of circular apertures having a selected constant center-to-center spacing between adjacent apertures, and an increasing aperture diameter at end portions of the aperture arrangement;
FIG. 12G depicts a plurality of apertures having a selected constant center-to-center spacing between adjacent apertures, and an increasing aperture size or aperture area at end portions of the aperture arrangement, with apertures at the end portions showing an oval outline extending in a direction perpendicular to the center line and apertures in a central portion showing a circular outline; and
FIG. 12H indicates a plurality of apertures with apertures at end portions of the aperture arrangement having an increasing aperture size or aperture area and a decreasing aperture spacing, with apertures at the end portions showing an oval outline extending along the center line and apertures in a central portion showing a circular outline;

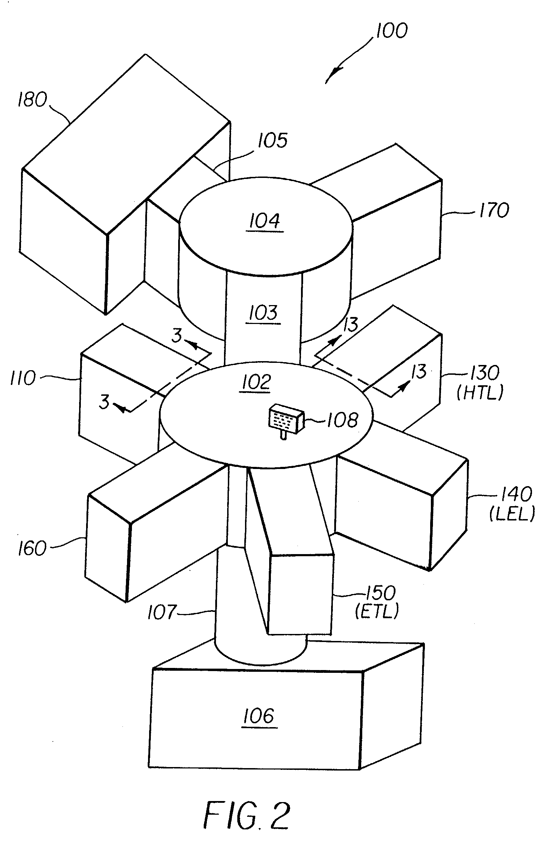

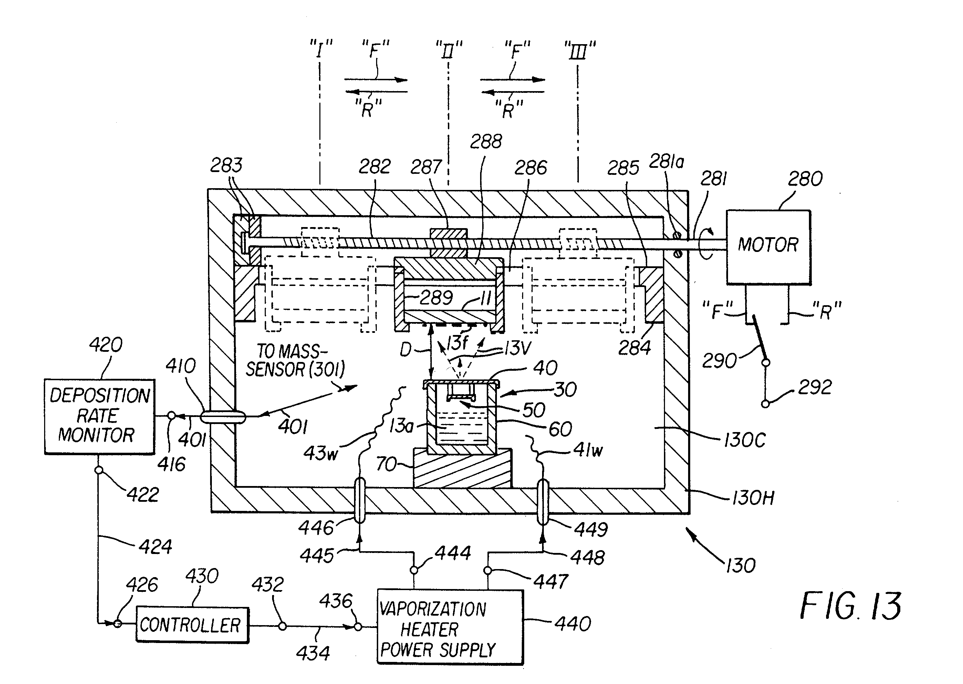

FIG. 13 is a schematic sectional view of a vapor deposition station dedicated to forming vapor-deposited organic hole-transporting layers (HTL) on structures in the OLED apparatus of FIG. 2 as indicated by section lines 13-13 in FIG. 2 and showing a structure being moved by a lead screw with respect to a fixedly disposed vapor deposition source to provide a uniformly vapor-deposited organic hole-transporting layer over the structure, in accordance with an aspect of the present invention;

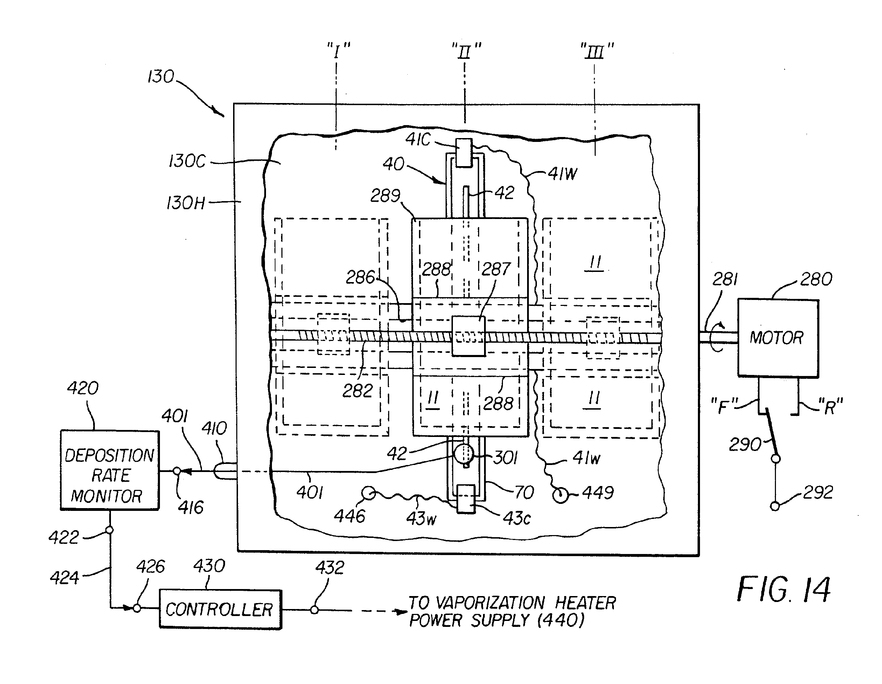

FIG. 14 is a schematic top view of a portion of the HTL vapor deposition station of FIG. 2 and showing a crystal mass-sensor disposed at an end portion of a plurality of vapor efflux apertures formed in the elongated vapor deposition source to receive a portion of the organic material vapor provided by the source for controlling the vapor deposition of an organic layer over the structure;

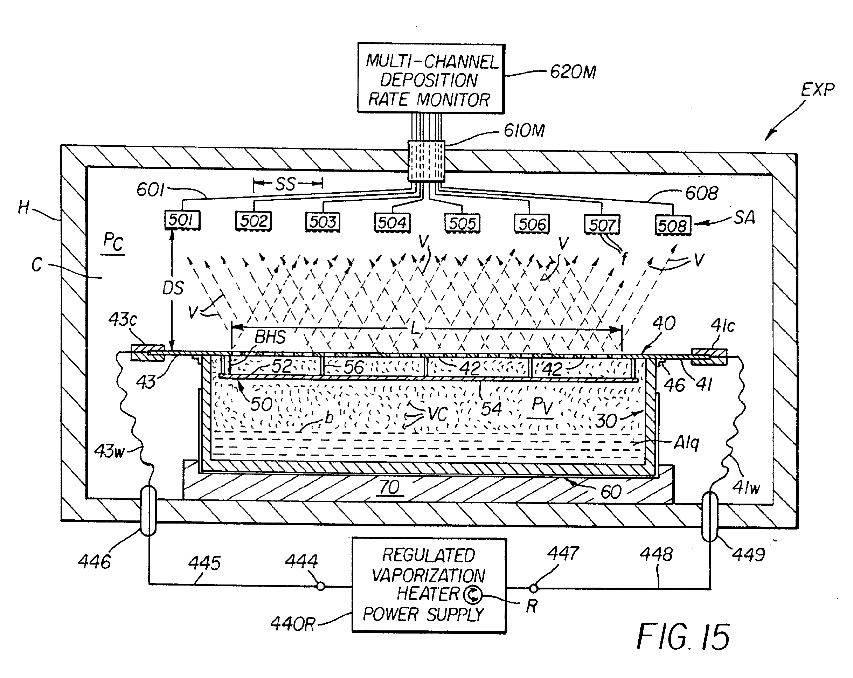

FIG. 15 indicates schematically an experimental station for determining the uniformity of vapor efflux of vaporized organic material from the plurality of vapor efflux apertures formed in the vaporization heater of the elongated vapor deposition source;

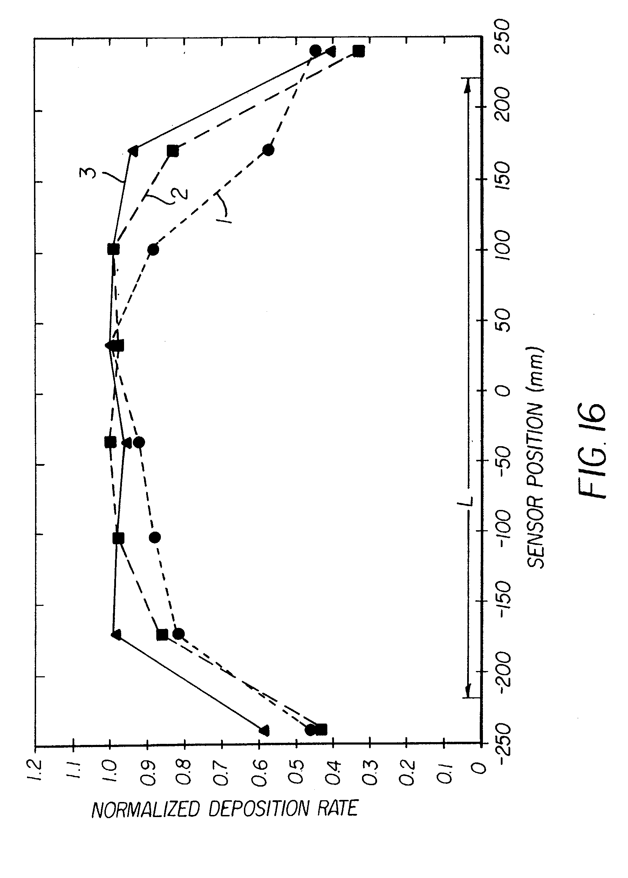

FIG. 16 is a graph showing a relative uniformity of a normalized vapor deposition rate (vapor efflux) determined in the station of FIG. 15 along the elongated direction of three elongated thermal physical vapor deposition sources including vaporization heaters having, respectively:
   i) a single-slit elongated vapor efflux aperture (a comparative example);
   ii) a plurality of vapor efflux apertures of a selected constant aperture size and a selected constant aperture spacing (another comparative example); and
   iii) a plurality of vapor efflux apertures of a selected constant aperture size and a decreasing aperture spacing at end portions of the aperture arrangement; and

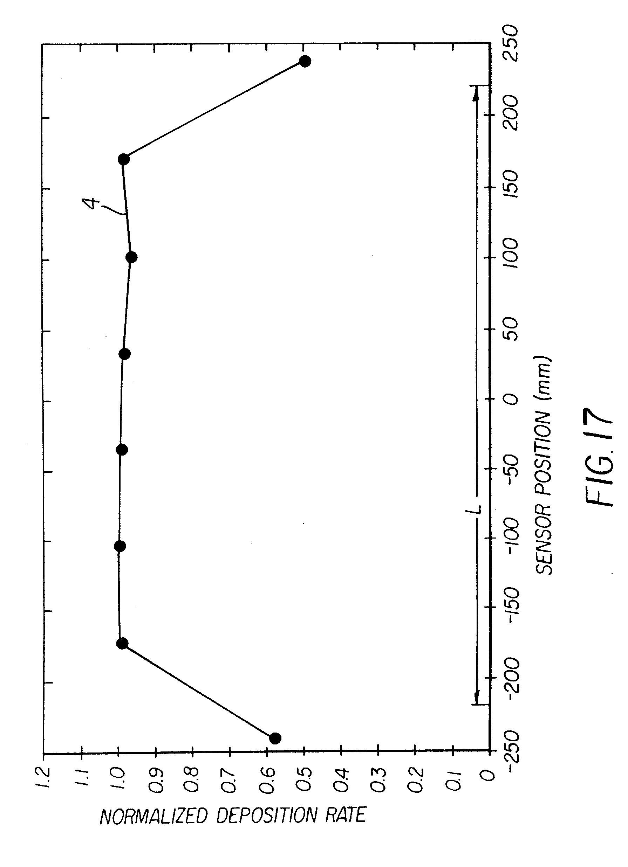

FIG. 17 is a graph showing a relative uniformity of a normalized vapor deposition rate determined along the elongated direction of the vapor deposition source having the vaporization heater described in (iii) above, wherein solid organic material in powdery form was received near one end only of the elongated electrically insulative container.

The drawings are necessarily of a schematic nature since layer thickness dimensions of OLEDs are frequently in the sub-micrometer ranges, while features representing lateral device dimensions can be in a range of 50-500 millimeter. Furthermore, the plurality of apertures formed in the vaporization heater is relatively small in size when compared to a length dimension over which the apertures extend along the elongated direction of the heater. Accordingly, the drawings are scaled for ease of visualization rather than for dimensional accuracy.

The term "substrate" denotes a light-transmissive support having a plurality of laterally spaced first electrodes (anodes) preformed thereon, such substrate being a precursor of a passive matrix OLED. The term "structure" is used to describe the substrate once it has received a portion of a vapor deposited organic layer, and to denote an active matrix array as a distinction over a passive matrix precursor.

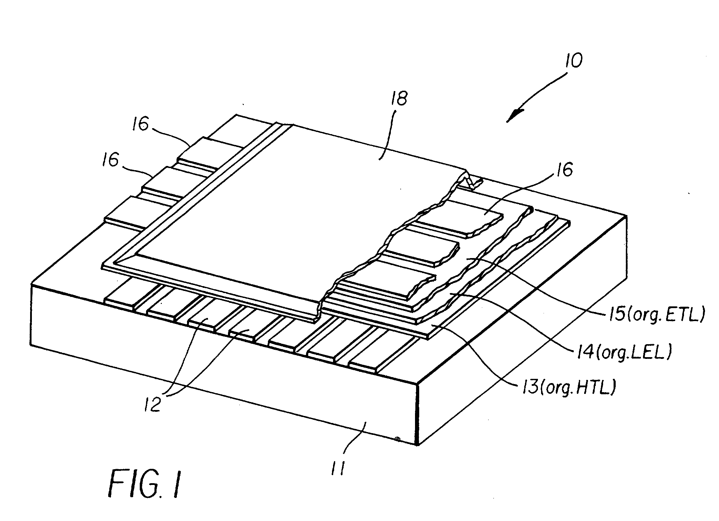

Turning to FIG. 1, a schematic perspective view of a passive matrix organic light-emitting device (OLED) 10 is shown having partially peeled-back elements to reveal various layers.

A light-transmissive substrate 11 has formed thereon a plurality of laterally spaced first electrodes 12 (also referred to as anodes). An organic hole-transporting layer (HTL) 13, an organic light-emitting layer (LEL) 14, and an organic electron-transporting layer (ETL) 15 are formed in sequence by a physical vapor deposition, as will be described in more detail hereinafter. A plurality of laterally spaced second electrodes 16 (also referred to as cathodes) are formed over the organic electron-transporting layer 15, and in a direction substantially perpendicular to the first electrodes 12. An encapsulation or cover 18 seals environmentally sensitive portions of the structure, thereby providing a completed OLED 10.

Turning to FIG. 2, a schematic perspective view of an OLED apparatus 100 is shown which is suitable for making a relatively large number of organic light-emitting devices using automated or robotic means (not shown) for transporting or transferring substrates or structures among a plurality of stations extending from a buffer hub 102 and from a transfer hub 104. A vacuum pump 106 via a pumping port 107 provides reduced pressure within the hubs 102, 104, and within each of the stations extending from these hubs. A pressure gauge 108 indicates the reduced pressure within the system 100. The pressure is typically lower than 10⁻³ torr (1.33 x 10⁻¹ pascal).

The stations include a load station 110 for providing a load of substrates or structures, a vapor deposition station 130 dedicated to forming organic hole-transporting layers (HTL), a vapor deposition station 140 dedicated to forming organic light-emitting layers (LEL), a vapor deposition station 150 dedicated to forming organic electron-transporting layers (ETL), a vapor deposition station 160 dedicated to forming the plurality of second electrodes (cathodes), an unload station 103 for transferring structures from the buffer hub 102 to the transfer hub 104 which, in turn, provides a storage station 170, and an encapsulation station 180 connected to the hub 104 via a connector port 105. Each of these stations has an open port extending into the hubs 102 and 104, respectively, and each station has a vacuum-sealed access port (not shown) to provide access to a station for cleaning, replenishing materials, and for replacement or repair of parts. Each station includes a housing, which defines a chamber.

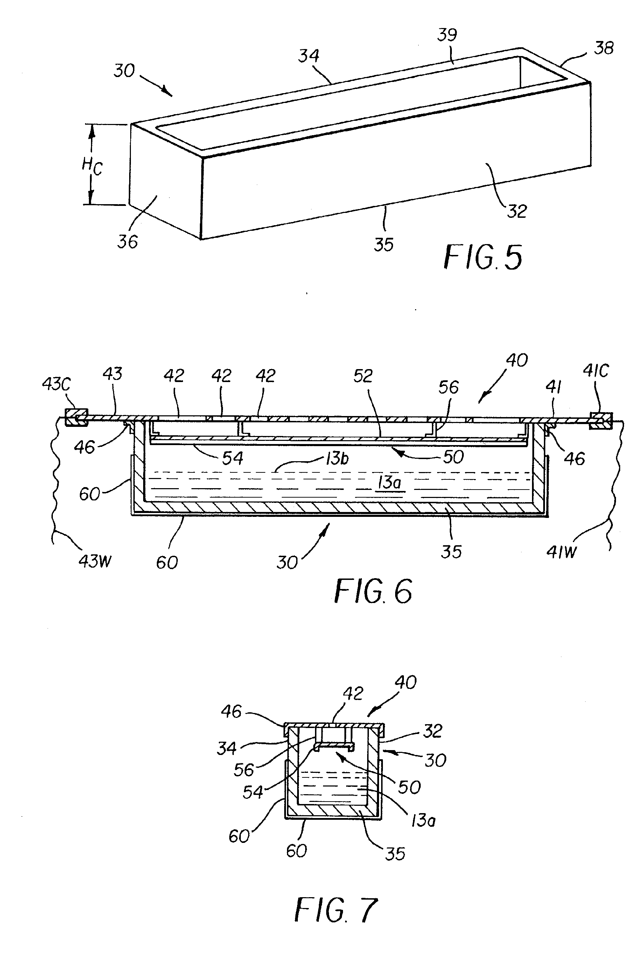

In the detailed description of FIGS. 6-9 and 13 and 14, organic hole-transporting material is depicted as an illustrative example of an organic material for forming an organic hole-transporting layer 13 (see FIG. 1) in the station 130 (ETL) of FIG. 2. It will be appreciated that a thermal physical vapor deposition source can be effectively used in accordance with aspects of the present invention to form an organic light-emitting layer 14 (see FIG. 1) in the station 140 (LEL) of FIG. 2, or to form an organic electron-transporting layer 15 (see FIG. 1) in the station 150 (ETL) of FIG. 2.

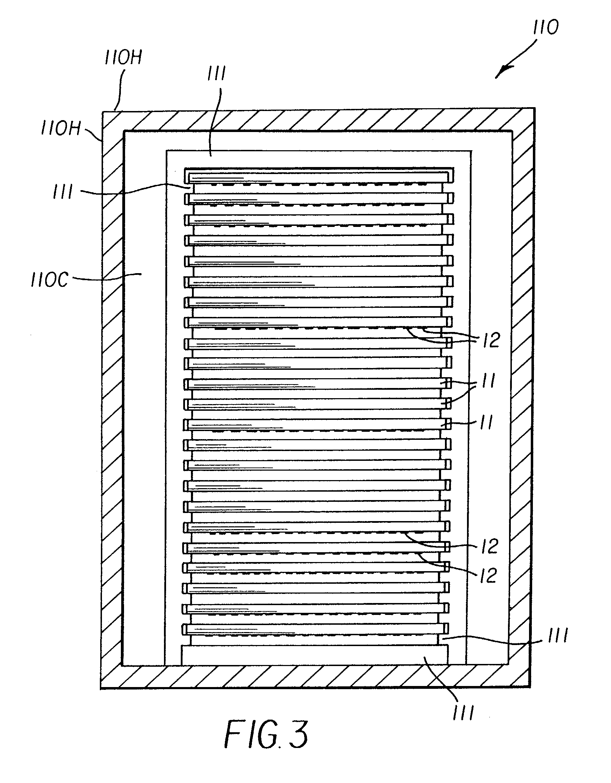

FIG. 3 is a schematic section view of the load station 110, taken along section lines 3-3 of FIG. 2. The load station 110 has a housing 110H, which defines a chamber 110C. Within the chamber is positioned a carrier 111 designed to carry a plurality of substrates 11 having preformed first electrodes 12 (see FIG. 1). An alternative carrier 111 can be provided for supporting a plurality of active matrix structures. Carriers 111 can also be provided in the unload station 103 and in the storage station 170.

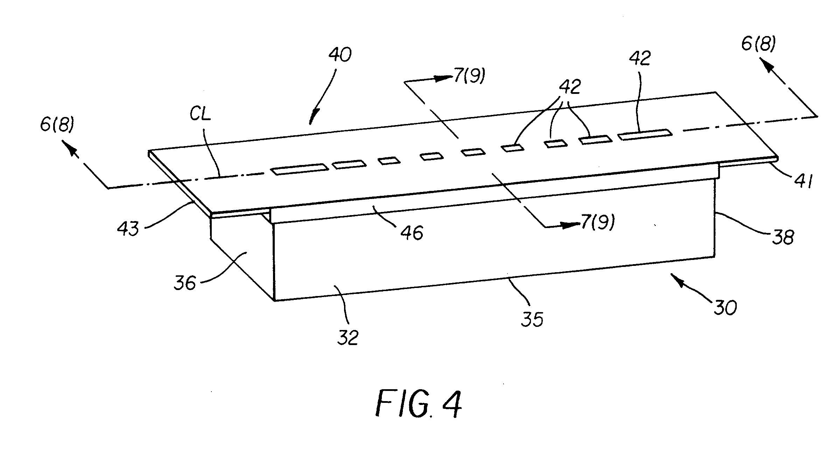

Turning to FIGS. 4 and 5, schematic perspective views are shown, respectively, of an elongated thermal physical vapor deposition source constructed in accordance with an aspect of the present invention, and of an elongated electrically insulative container 30 for receiving solid organic material, which can be vaporized

The container 30 is defined by side walls 32, 34, end walls 36, 38, and a bottom wall 35. Side walls 32, 34 and end walls 36, 38 share a common upper surface 39. The electrically insulative container 30 is preferably constructed of quartz or of a ceramic material. The container has a height dimension H_{c}.

An elongated vaporization heater 40, which forms a cover for the container, is sealingly disposed over the common upper surface 39 of the container 30 via a sealing flange 46 which forms part of the vaporization heater. A second sealing flange (not shown in the drawings), also attached to the vaporization heater 40, can be used to provide a second seal between the source and interior portions of the side walls 32, 34 and end walls 36, 38. Other sealing elements can be used advantageously, for example, ceramic seals, or seals constructed of a temperature-tolerant compliant material. Such seals can be used in conjunction with the sealing flange 46.

The elongated vaporization heater 40 is substantially planar, and includes electrical connecting flanges 41, 43. The vaporization heater 40 and the sealing flange 46 (and a second sealing flange, if used) are preferably constructed of tantalum metal sheet material which has moderate electrical conductivity, superior mechanical strength and stability in repeated use cycles at elevated "vaporization" temperature, and an ability to be readily shaped into a desired shape.

A plurality of vapor efflux apertures 42 are formed about a center line CL along the elongated direction of the vaporization heater. The apertures 42 extend through the vaporization heater 40 to cause vapor of organic material formed in the container (when the heater is heated to cause vaporization of such organic material) to issue from the apertures and to be directed toward a surface of a structure to provide an organic layer thereon, as will be described with reference to FIG. 13.

The vapor efflux apertures 42 are spaced from one another by the tantalum metal sheet material used to construct the heater 40. Each one of the plurality of apertures is therefore protected from mechanical distortion of opposing aperture edges, and planarity of the heater 40 and its apertures 42 is maintained over numerous vapor deposition cycles.

The vapor efflux apertures can be formed by several known techniques, for example, laser-machining and wet or dry etching. Various aperture outlines, aperture sizes or aperture areas, and aperture spacings can be formed by such techniques. Such features will be described in greater detail with reference to FIGS. 12A-12H.

Turning to FIG. 6, a schematic sectional view of the elongated vapor deposition source of FIG. 4 is shown, taken along the elongated direction as indicated by the section lines 6-6 in FIG. 4.

The elongated electrically insulative container 30 includes a heat-reflective coating 60 formed over the bottom wall 35 of the container, and extending upwardly over portions of the side walls and end walls of the container. The heat-reflective coating is shown here (and in FIGS. 7, 8, and 9) to be formed over exterior surfaces of the container 30. Such coating can be formed over interior surfaces of the container, or over both exterior and interior surfaces. The heat-reflective coating or coatings can be formed of a multilayer dielectric stack designed to reflect heat radiation back into the container. Alternatively the heat-reflective coating can be formed of a metal or metals having mirror-like reflective properties, such as a metal foil.

The container 30 has received a charge of solid organic material, which can be vaporized. Solid organic hole-transporting material 13a in powder form extends to a level 13b in the container. The term "powder" includes flakes and particulates of solid organic material.

A baffle member 50 is attached mechanically and electrically to an underside of the vaporization heater 40 by a plurality of baffle supports 56 which also provide a selected spacing (shown as a spacing BHS in FIG. 15) between an upper surface 52 of the baffle member and the vaporization heater 40. Further mechanical stability of the baffle member 50 in the elongated direction is provided by baffle stabilizers 54. The baffle member 50, supports 56, and stabilizers 54 are preferably constructed of tantalum metal sheet material, as is the vaporization heater 40. The baffle supports 56 can be spot-welded to the baffle member 50 and to the vaporization heater 40.

The baffle member 50 is sized and positioned with respect to the plurality of vapor efflux apertures 42 of the vaporization heater 40, so that the baffle member substantially provides a line-of-sight covering of these apertures to prevent direct access of vaporized organic materials to the apertures, and to prevent particulate organic materials from passing through the plurality of apertures.

A baffle member and its positioning with respect to a single slit vapor efflux aperture has been disclosed by Robert G. Spahn in the aforementioned commonly assigned US-A-6,237,529, issued May 29, 2001, the disclosure of which is herein incorporated by reference.

A connecting clamp 41c serves to connect an electrical lead 41w to the electrical connecting flange 41 of the vaporization heater 40. Similarly, a connecting clamp 43c serves to connect an electrical lead 43w to the electrical connecting flange 43.

Turning to FIG. 7, a schematic sectional view of the vapor deposition source of FIG. 4 is taken in a direction perpendicular to the elongated direction of the source, as indicated by the section lines 7-7 in FIG. 4. The baffle stabilizers 54 can be formed by bending a previously planar baffle element into a U-shape, or by spot-welding baffle stabilizers to a planar baffle element.

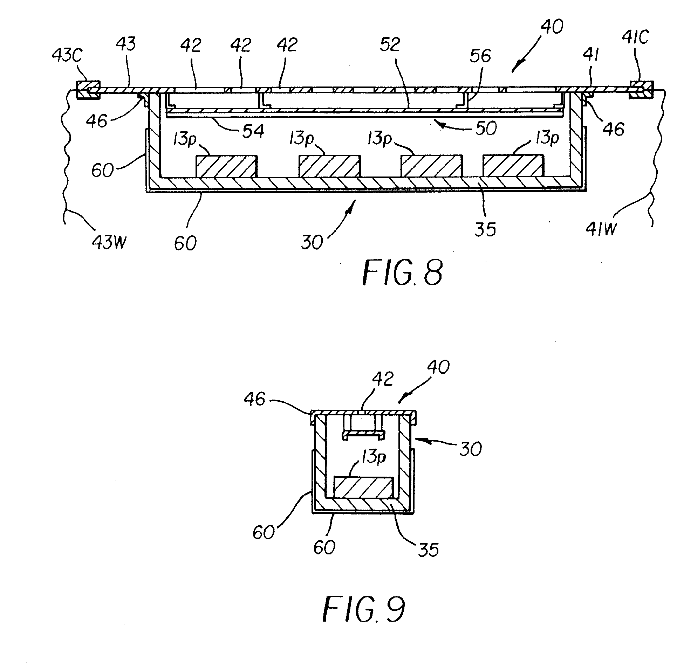

Viewing FIG. 8 and FIG. 9 together, these sectional views of the vapor deposition source are identical to the sectional views of FIG. 6 and FIG. 7, respectively, except that the solid organic material received in the container 30 is in the form of solid pellets 13p of organic hole-transporting material. The preparation of such solid organic pellets, also referred to as agglomerated organic pellets, has been disclosed by Steven A. Van Slyke, and others in commonly assigned U.S. Patent Application Serial No. 09/898,369, filed July 3, 2001, entitled "Method of Handling Organic Material in Making an Organic Light-Emitting Device", the disclosure of which is herein incorporated by reference.

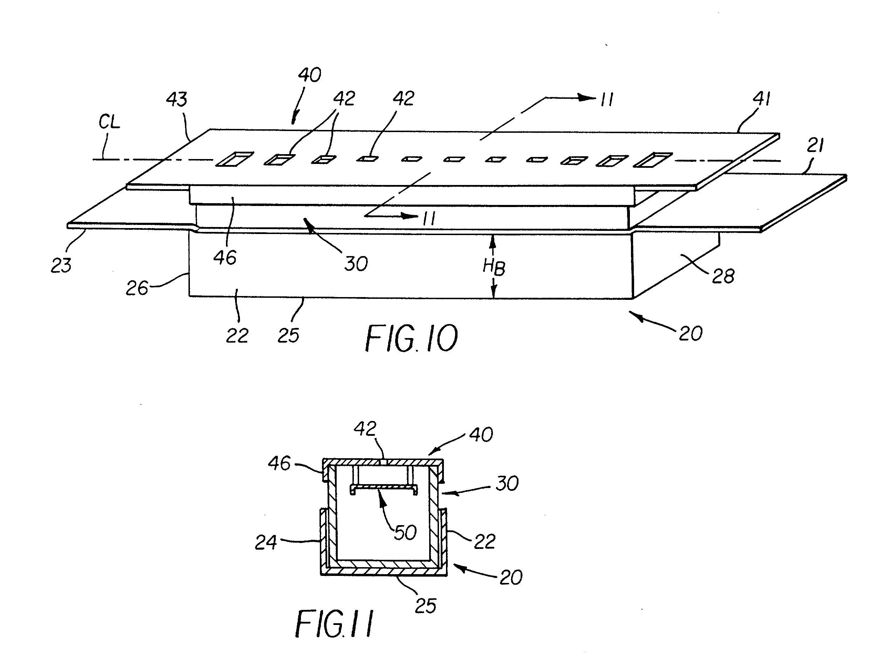

Turning to FIG. 10, a schematic perspective view of another embodiment of an elongated thermal physical vapor deposition source having a plurality of vapor efflux apertures is shown, in which an elongated electrically insulative container 30 is disposed in an elongated bias heater 20, and an elongated vaporization heater 40 is sealingly disposed on common upper surfaces of the container 30. The bias heater has a height dimension H_{B}, which is less than a height dimension H_{c} of the container (see FIG. 5).

The bias heater 20 has side walls 22, 24, end walls 26, 28, and a bottom wall 25. Electrical connecting flanges 21 and 23 extend from the end walls 28 and 26, respectively. The bias heater 20 is preferably constructed of tantalum metal sheet material.

During operation of the elongated thermal physical vapor deposition source in a chamber held at reduced pressure, an electrical potential is applied to the bias heater 20 via electrical leads (not shown) connected to respective electrical connecting flanges 21, 23 by connecting clamps (not shown). The applied electrical potential is selected to cause current flow through the bias heater which, in turn, causes bias heat to be applied to solid organic material received in the container 30 to provide a bias temperature which is insufficient to cause the solid organic material to vaporize. However, the bias temperature is sufficient to release entrained gases and/or entrained moisture or volatile compounds from the organic material received in the container 30.

The vaporization heater 40, its electrical connecting flanges 41, 43, and the sealing flange 46 are the same elements described with respect to FIGS. 4, and 6-9. The plurality of vapor efflux apertures 42 are depicted having aperture outlines which differ from the aperture outlines shown in the embodiment of FIG. 4. Various shapes, outlines, and arrangements of vapor efflux apertures are shown in greater detail in FIGS. 12A-12H.

While the bias heater 20 is operative, an electrical potential is applied to the vaporization heater 40 via electrical leads (not shown) connected to the electrical connecting flanges 41, 43 via respective connecting clamps (not shown). The electrical potential applied to the vaporization heater causes vaporization heat to be applied to uppermost portions of the solid organic material in the container 30, causing such uppermost portions to vaporize, so that vaporized organic material is projected off the side walls 32, 34 and the end walls 36, 38 of the container 30, lower surfaces of the vaporization heater 40, and the upper surface 52 of the baffle member, to exit the source through the plurality of vapor efflux apertures 42 and to project a vapor stream onto the substrate or structure 11 to provide an organic layer on the structure.

Relative motion between the elongated source of FIG. 10 and the substrate or structure 11 is provided, and in a direction substantially perpendicular to the elongated direction of the source to form an organic layer having improved uniformity.

FIG. 11 is a schematic sectional view of the elongated vapor deposition source, taken along the section lines 11-11 of FIG. 10, and showing the baffle member 50. The electrically insulative container 30 does not include the heat-reflective coating 60 in the embodiment having the bias heater 20.

A vapor deposition source which includes a bias heater 20, an electrically insulative container 30 disposed in the bias heater, and a vaporization heater 40 having a single-slit vapor efflux aperture disposed on the container is disclosed by Steven A. Van Slyke, and others in U.S. Patent Application Serial No. 09/996,415, filed November 28, 2001, commonly assigned, and entitled "Thermal Physical Vapor Deposition Source for Making an Organic Light-Emitting Device."

Turning to FIGS. 12A-12H, schematic plan views are shown of various examples of an elongated vaporization heater having a plurality of spaced vapor efflux apertures arranged with respect to a center line which extends along an elongated direction of the vaporization heater. The plurality of vapor efflux apertures defined in the vaporization heater include apertures having a polygonal outline, a circular outline, an ellipsoidal outline, an oval outline, or a combination of such aperture outlines or aperture shapes.

FIG. 12A depicts a vaporization heater 40A having a plurality of apertures 42A arranged with respect to a center line CL. Each of the apertures has a generally rectangular outline and a height dimension h to define a selected constant aperture area a, also referred to as an aperture size in portions of the present application. Throughout a central portion cp of the aperture arrangement, the apertures have a selected spacing s between apertures. Towards end portions ep of the aperture arrangement, the aperture spacing decreases progressively from the spacing s to a spacing s3, wherein s3<s2<sl<s.

FIG. 12B shows a vaporization heater 40B having a plurality of apertures 42B arranged with respect to a center line CL. Each of the apertures has a generally rectangular outline and a height dimension h to define a selected aperture area a in a central portion cp, and progressively increasing aperture areas a1, a2, a3 towards end portions ep of the aperture arrangement, wherein a<a1<a2<a3. The spacing s between apertures has a selected constant value.

FIG. 12C indicates a vaporization heater 40C having a plurality of apertures 42C arranged with respect to a center line CL. Each of the apertures has a generally rectangular outline and a height dimension h to define a selected aperture area a in a central portion cp, and progressively increasing aperture areas a1, a2 towards end portions ep of the aperture arrangement, wherein a<a1<a2. The spacing between apertures decreases progressively from a selected value s in the central portion to spacings s1, s2 towards the end portions, wherein s2<sl<s.

The plurality of apertures 42 depicted in FIGS. 4, 6, and 8 have an aperture arrangement which is similar to the arrangement of FIG. 12C described above.

FIG. 12D shows a vaporization heater 40D having a plurality of apertures 42D arranged with respect to a center line CL. The spacing s between apertures has a selected constant value. Apertures in a central portion cp have a generally rectangular outline to define a selected aperture area a. Apertures near end portions ep are shown with a trapezoidal outline of progressively increasing aperture areas a1, a2, a3, wherein a<a1<a2<a3.

The plurality of apertures 42 depicted in FIG. 10 have an aperture arrangement, which is similar to the arrangement of FIG. 12D described above.

FIG. 12E indicates a vaporization heater 40E having a plurality of apertures 42E arranged with respect to a pattern center line PCL. Each of the apertures has a generally rectangular outline and a height dimension h to define a selected constant aperture area a. The spacing s between apertures has a selected constant value along the elongated direction of the aperture arrangement. A pattern of parallel rows of apertures is defined at end portions ep of this aperture arrangement with respect to the pattern center line while a single row of apertures is defined throughout a central portion cp.

FIG. 12F depicts a vaporization heater 40F having a plurality of apertures 42F arranged with respect to a center line CL. Each of the apertures has a circular outline, and the apertures have a center-to-center spacing cs of a selected value. Throughout a central portion cp, the apertures have a selected constant diameter d. Toward end portions ep, the diameter of apertures increases progressively from d to d1, d2, d3, d4, wherein d<d1<d2<d3<d4.

FIG. 12G shows a vaporization heater 40G having a plurality of apertures 42G arranged with respect to a center line CL. The apertures have a selected center-to-center spacing cs. Throughout a central portion cp of the aperture arrangement, apertures have a circular outline of a selected diameter d. Towards end portions ep of the aperture arrangement, apertures have an oval outline or an ellipsoidal outline extending in a direction perpendicular to the center line CL, and having a progressively increasing height dimension h1, h2, h3, wherein d<h1<h2<h3.

FIG. 12H indicates a vaporization heater 40H having a plurality of apertures 42H arranged with respect to a center line CL. Throughout a central portion cp of the aperture arrangement, apertures are shown with a circular outline of a selected diameter d and a selected center-to-center spacing cs. Towards end portions ep of the aperture arrangement, apertures have an oval outline or an ellipsoidal outline extending in a direction of the center line CL, and having a progressively increasing length dimension l1, l2, and a progressively decreasing spacing s1, s2 between these apertures, wherein d<l1<l2, and s2<s1<cs. The diameter d of the circular apertures and a height dimension h of the oval or ellipsoidal apertures are shown to have the same value.

From the description of FIGS. 12A-12H, it will be appreciated that various additional aperture outlines can be contemplated such as, for example, hexagonal outlines, as well as combinations of polygonal apertures with circular, oval, or ellipsoidal apertures to achieve improved uniformity of vapor efflux of vaporized organic material along the elongated direction of the elongated vapor deposition source.

Due to the necessarily schematic nature of the drawings, it may appear that the central portions cp of the aperture arrangements extend over a distance comparable to a sum of distances which are described as end portions ep. In a practical elongated thermal physical vapor deposition source constructed with a plurality of vapor efflux apertures, the central portion of apertures can be significantly longer than the end portions of an aperture arrangement. As the source to substrate separation is decreased, for example, the central portion of apertures is significantly longer compared to the end portions of the aperture arrangement.

Turning to FIG. 13, a schematic sectional view of the vapor deposition station 130 of FIG. 2 is shown which is dedicated to forming vapor-deposited organic hole-transporting layers (HTL) on structures or substrates by using an elongated vapor deposition source of the present invention. The station 130 has a housing 130H, which defines a chamber 130C. A substrate or structure 11 is supported in a holder and/or in a mask frame 289 within the chamber 130C which is at reduced pressure (see FIG. 2), typically at a pressure lower than 10⁻³ torr.

The thermal physical vapor deposition source of the present invention is shown in the sectional view depicted in FIG. 7, and is supported by a thermally and electrically insulative source support 70. Electrical leads 41w and 43w are schematically shown directed toward the source from respective power feedthroughs 449 and 446 disposed in the housing 130H.

In FIG. 13, and also in FIG. 14, relative motion between the substrate or structure 11 and the vapor deposition source, during vapor deposition of organic hole-transporting material 13a in a deposition zone 13v of vapor of organic hole-transporting material, is provided by moving or translating the substrate or structure 11 with respect to the source The vapor deposition source, that is, the plurality of apertures 42 defined in the vaporization heater 40, has a spacing D from the substrate or structure 11.

In an intermediate vapor deposition position "II", the substrate or structure 11, the holder and/or mask frame 289, a glide shoe 288, and a lead screw follower 287 are shown in solid-outline sectional view. These source elements are depicted in dotted and dashed outlines in a starting position "I" of the holder 289, and in an end position "III" of a forward motion "F" of the holder, which is also the beginning position of a reverse motion "R" (or return motion "R") of the holder.

Forward motion "F" and reverse or return motion "R" are effected by a lead screw 282 which engages the lead screw follower 287. The follower 287 is attached to the glide shoe 288, which, in turn, supports the holder and/or mask frame 289. The glide shoe 288 glides along a glide rail 285, and is guided in a glide rail groove 286 formed in the glide rail 285. The glide rail 285 is supported by glide rail brackets 284, which may be fastened to the housing 130H, as shown in FIG. 13.

The lead screw 282 is supported at one end by a lead screw shaft termination bracket 283, and a lead screw shaft 281 is supported in the housing 130 by a shaft seal 281a. The lead screw shaft 281 extends through the housing 130 to a motor 280.

The motor 280 provides for forward motion "F" or reverse motion "R" via switch 290 which provides a control signal to the motor from an input terminal 292. The switch can have an intermediate or "neutral" position (not shown) in which the holder 289 can remain in either the end position "III" of forward motion, or in the starting position "I" in which a substrate or structure 11 with a completed organic layer is removed from the holder and/or mask frame 289 and a new substrate or structure is positioned in the holder.

Located near an end portion within the deposition zone 13v, and outside the dimensions defined by the substrate or structure 11, is a crystal mass-sensor 301, as shown in FIG. 14 The crystal mass-sensor 301 intercepts a fraction of the vapor of organic material issuing from vapor efflux apertures at end portions ep of the plurality of apertures. The vapor condenses on the sensor to form a layer, thereby depositing mass on the sensor in the same manner as the vapor condenses on the substrate or structure 11 to form a layer on the substrate.

Sensor 301 is connected via a sensor signal lead 401 and a sensor signal feedthrough 410 to an input terminal 416 of a deposition rate monitor 420. The monitor 420 provides for selection of a desired vapor deposition rate, that is, a desired rate of mass build-up on the structure 11 and on the sensor 301, and the monitor includes an oscillator circuit (not shown) which includes the crystal mass-sensor 301, as is well known in the art of monitoring vapor deposition processes. The deposition rate monitor 420 provides an output signal at an output terminal 422 thereof, and this monitor output signal becomes an input signal to a controller or amplifier 430 via a lead 424 at an input terminal 426. An output signal at output terminal 432 of the controller or amplifier 430 is connected via a lead 434 to an input terminal 436 of a vaporization heater power supply 440. The vaporization heater power supply 440 has two output terminals 444 and 447 which are connected via respective leads 445 and 448 to corresponding power feedthroughs 446 and 449 disposed in the housing 130H. The elongated vaporization heater 40, in turn, is connected to the power feedthroughs 446, 449 with electrical leads 43w and 41w, respectively, as depicted schematically in wavy outline in FIGS. 13 and 14.

As indicated schematically in FIG. 13 by bolded dashed lines, an organic hole-transporting layer 13f is being formed on the substrate or structure 11 during the forward motion "F" of the structure from the starting position "I" through the intermediate vapor deposition position "II" towards the end position "III" of forward motion. A completed organic hole-transporting layer 13 (see FIG. 1) is provided during a second pass of the substrate or structure through the deposition zone defined by vapors 13v in the reverse motion "R" from the end position "III", through the intermediate vapor deposition position "II", for termination at the starting position "I".

Upon termination at position "I", the completed structure is removed from the chamber 130C via robotic means (not shown) disposed in the buffer hub 102 (see FIG. 2), and the structure is advanced to another station, for example station 140, of the OELD apparatus 100 of FIG. 2. A new substrate or structure is advanced into the holder and/or mask frame 289 for vapor deposition of an organic hole-transporting layer 13 in the manner described above.

Turning to FIG. 14, a schematic top view of a portion of the HTL vapor deposition station 130 of FIG. 2 is shown which shows more clearly the placement of the crystal mass-sensor 301 at or near an end portion of the plurality of vapor efflux apertures 42, and at a position outside an area delineated by the substrate or structure 11. Also shown more clearly are the connecting clamps 41c, 43c which connect corresponding electrical leads 41w and 43w to respective electrical connecting flanges 41, 43 of the vaporization heater 40, as described with reference to FIG. 6.

In order to preserve clarity of the drawings of FIGS. 13 and 14, only the single crystal mass-sensor 301 is shown. Various other sensor configurations and methods for sensing and controlling vapor deposition of organic layers of an OLED can be used effectively in the practice of the present invention. For example, Michael A. Marcus and others disclose a reusable mass-sensor in commonly assigned U.S. Patent Application Serial No. 09/839,886, filed April 20, 2001, the disclosure of which is herein incorporated by reference. Reusable optical sensing assemblies can also be used effectively in the practice of the present invention to make an OLED. Various optical sensing approaches have been used in controlling the thickness of an organic layer in making an OLED, as disclosed by Steven A. Van Slyke and others. in commonly assigned U.S. Patent Application Serial No. 09/839,885, filed April 20, 2001, the disclosure of which is herein incorporated by reference.

In FIGS. 13 and 14, the substrate or structure 11 is moved with respect to a fixedly disposed elongated vapor deposition source having the plurality of vapor efflux apertures 42, and in a direction substantially perpendicular to the elongated direction of the source.

Relative motion between the substrate or structure 11 and the elongated vapor deposition source having the plurality of vapor efflux apertures 42 is provided by moving the source with respect to a fixedly disposed substrate or structure by a lead screw which engages a movable carriage or other movable transport means on which the elongated vapor deposition source can be positioned. Alternatively, the substrate can be moved relative to the elongated vapor deposition source.

The drawings of FIGS. 2, 6, 7, 8, 9 and 13, 14 show, for illustrative purposes only, organic hole-transporting material and formation of an organic hole-transporting layer on a structure in the station 130, which is dedicated to that purpose in the OLED apparatus 100 of FIG. 2. It will be understood that doped or undoped organic hole-transporting layers 13 can be prepared by using one or more sources constructed in accordance with the present invention. Similarly, doped or undoped organic light-emitting layers 14 can be formed, and doped or undoped organic electron-transporting layers 15 can be vapor deposited onto a structure in respectively dedicated stations of the OLED apparatus 100 of FIG. 2. Also, a doped or undoped organic hole-injecting layer (not shown in the drawings) can be formed as a first layer on a structure.

The use of dopants to provide a doped layer on a structure has been described, for example, in the above-referenced US-A-4,769,292 in which one or more dopants are incorporated in an organic light-emitting layer to provide a shift of color or hue of emitted light. Such selected shifting or change of color is particularly desirable when constructing a multi-color or full-color organic light-emitting device.

So-called color-neutral dopants can be effectively used in conjunction with an organic hole-transporting layer and/or in conjunction with an organic electron-transporting layer to provide an organic light-emitting device having enhanced operational stability or extended operational life time, or enhanced electroluminescent efficiency. Such color-neutral dopants and their use in an organic light-emitting device are disclosed by Tukaram K. Hatwar and Ralph H. Young in commonly assigned U.S. Patent Application serial No. 09/875,646, filed June 6, 2001, the disclosure of which is hereby incorporated by reference.

The use of a uniformly mixed organic host layer having at least two host components is disclosed by Ralph H. Young, and others in commonly assigned U.S. Patent Application Serial No. 09/753,091, filed January 2, 2001, the disclosure of which is herein incorporated by reference.

The elongated thermal physical vapor deposition source of the present invention can also be effectively used to form a uniform layer of one or more organic dopants onto a structure by vapor deposition or by vapor codeposition from one or more elongated sources having a plurality of vapor efflux apertures. The dopant or dopants are received in an elongated electrically insulative container 30 in the form of powders, flakes, or particles, or in the form of agglomerated pellets.

The elongated thermal physical vapor deposition source of the present invention can also be effectively used to form a uniform layer of one or more organic host materials and one or more organic dopant materials by vapor deposition from one elongated source having a plurality of vapor efflux apertures. The host material(s) and the dopant material(s) are received in an elongated electrically insulative container 30 in the form of powders, flakes, or particles, or in the form of agglomerated pellets.

### EXAMPLES

Before describing the following examples, an experimental vapor deposition station EXP is shown in the schematic cross-sectional view of FIG. 15. This experimental station is used to determine the uniformity of vapor efflux of a vaporized organic material from a single-slit vapor efflux aperture and from a plurality of vapor efflux apertures formed in three different elongated vaporization heaters 40 which are sealingly disposed over an elongated electrically insulative container 30.

In FIG. 15, like parts having like functions are shown with like numeral designations with reference to the descriptions of FIGS. 4, 5, 6, 7, and 13. For example, the heat-reflective coating 60 of the elongated container has been described with reference to FIGS. 6, 7. The electrical connecting flanges 41, 43 of the vaporization heater correspond to the same electrical connecting flanges described with reference to FIG. 6. Accordingly, like parts will not be described in detail here.

The experimental station EXP includes a housing H that defines a chamber C. The chamber is evacuated by a vacuum pump (not shown) to a reduced pressure P_{c} which, for each of the following examples, was 10⁻⁶ torr (1.33 x 10⁻⁴ pascal).

Disposed in the chamber C is the elongated container 30, supported by the thermally and electrically insulative source support 70, and an elongated vaporization heater 40 sealingly positioned over the container 30 via sealing flange 46. In each of the following examples, the container 30 received a charge of a solid organic electron-transporting material in powder form. This organic material was tris(8-quinolinolato-Nl, 08) aluminum, an aluminum chelate, abbreviated as Alq.

A single-slit vapor efflux aperture, or a plurality of vapor efflux apertures, formed in the vaporization heater 40, extend over a length dimension L in the elongated direction of the heater. In each of the following examples, L was 440 millimeter (mm). This length was chosen to provide uniform deposition over a 300 mm wide deposition region.

An upper surface 52 of the baffle member 50 has a spacing BHS to a lower surface (not identified) of the vaporization heater 40, and the baffle member 50 has a width dimension (not shown in FIG. 15). In each of the following examples, the spacing BHS was 2 mm, and the baffle width was 20 mm.

Also disposed in the chamber C is a sensor array SA having eight crystal mass-sensors 501 to 508. The sensor array SA is spaced from the vaporization heater(s) 40 by a distance DS. A uniform sensor-to-sensor spacing SS is selected so that the sensors 501 and 508 have sensor positions, which extend beyond respective terminations of a single-slit vapor efflux aperture or of a plurality of vapor efflux apertures. In each of the following examples, the sensor array SA was spaced from the vaporization heater by a distance DS of 100 mm, and the sensor-to-sensor spacing SS was 68.5 mm.

Each of the crystal mass sensors 501-508 has a corresponding sensor signal lead 601 to 608 (only signal leads 601 and 608 are identified in FIG. 15), and these sensor signal leads are connected to corresponding input terminals (not shown) of a multichannel deposition rate monitor 620M via a multilead sensor signal feedthrough 610M. The monitor 620M is adapted to indicate periodically and sequentially sensor signals of the crystal mass-sensors 501 to 508 wherein the sensor signals correspond to a rate of mass build-up on the sensors as a layer of Alq is being formed on each sensor, depicted at fin dotted outline, by condensation of Alq vapors v which define a deposition zone shown in dashed and directional outline.

The vaporization heater 40 is heated by a regulated vaporization heater power supply 440R which includes a regulator R that is adjusted to heat the vaporization heater to cause uppermost portions of the Alq material in the container 30 to vaporize. It is known from independent measurements that a vapor pressure Pᵥ of vapors of organic materials, which can be vaporized, can be several orders of magnitude higher than the pressure P_{c} in the chamber C. If the vapor efflux apertures are sized and configured so as to control vapor efflux with respect to a rate of vaporization of solid organic material in the container 30 by the vaporization heater 40, a vapor cloud VC is formed and spread relatively uniformly in a space between still solid organic material (Alq) in the container 30 and the baffle member 50 and in a space between the baffle member and the vaporization heater 40, as schematically shown in curled outlines. As the vapor cloud VC penetrates or permeates the spacing BHS between the baffle member 50 and the vaporization heater 40, a portion of the vapor cloud can exit through the vapor efflux aperture(s) as vapor streams v into the reduced-pressure environment characterized by the pressure Pc in the chamber C.

In FIG. 15, the vaporization heater 40 is shown having a plurality of vapor efflux apertures 42 which resemble the arrangement of apertures 42A of FIG. 12A, and a similar arrangement of apertures is used in a vaporization heater selected in Examples 3, 4, and 5.

The invention and its advantages are further illustrated by the following specific examples.

### Comparative Example 1

An elongated vaporization heater of the prior art was sealingly disposed over the elongated container 30 of FIG. 15. This prior art heater had a single-slit vapor efflux aperture of a length dimension L of 440 mm, and the slit had a width dimension of 0.127 mm. Alq in powder form had been received in the elongated container 30 as a relatively uniform charge to a fill-level b of approximately 12.5 mm, as depicted in horizontal dashed outline in FIG. 15.

The vaporization heater was heated by adjusting the regulator R of the regulated vaporization heater power supply 440R to heat the heater to a temperature which caused uppermost portions of the solid Alq material to vaporize, and which provided a deposition rate indication on the monitor 620M from each of the crystal mass-sensors 501 to 508.

Relative uniformity of a normalized deposition rate (normalized with respect to signals provided by crystal mass-sensor 504 and/or sensor 505 of FIG. 15) along the elongated direction of the vaporization heater of Comparative Example 1 is shown in FIG. 16 as a trace 1 in dotted outline.

### Comparative Example 2

Another elongated vaporization heater was sealingly disposed over the elongated container 30 of FIG. 15. This heater had a plurality of rectangular vapor efflux apertures extending over a length dimension L of 440 mm. Each aperture was 10 mm long along the elongated direction of the heater, and the apertures were spaced from one another by 1.0 mm. All apertures had a width dimension of 0.127 mm (the width dimension is referred to as a height dimension h in FIGS. 12A-12C, and FIG. 12E). Alq in powder form had been received in the elongated container 30 as a relatively uniform charge to a fill-level b of approximately 12.5 mm, as depicted in horizontal dashed outline in FIG. 15.

The vaporization heater was heated in a manner described in Comparative Example 1 to actuate vaporization of uppermost portions of the solid Alq material.

Relative uniformity of a normalized deposition of Comparative Example 2 is shown in FIG. 16 as a trace 2 in dashed outline.

### Example 3

An elongated vaporization heater, having a plurality of rectangular vapor efflux apertures arranged in accordance with the present invention was sealingly disposed over the elongated container 30 of FIG. 15. The vapor efflux apertures extended over a length dimension L of 440 mm. Each aperture was 5.0 mm long. Over a central portion cp, the apertures had a spacing of 5.0 mm. Towards end portions ep of the aperture arrangement, two apertures were spaced by 4.0 mm, followed by two apertures spaced by 3.0 mm, followed by two apertures spaced by 2.0 mm. All apertures had a width dimension of 0.127 mm (that is, the height dimension h of, for example, the rectangular apertures 42A of FIG. 12A).

Alq in powder form had been received in the elongated container 30 as a relatively uniform charge to a fill-level 2xb of approximately 25 mm.

The vaporization heater was heated in a manner described in Comparative Example 1 to effect vaporization of uppermost portions of the solid Alq material.

Relative uniformity of a normalized deposition rate of Example 3 is shown in FIG. 16 as a trace 3 in solid outline.

### Example 4

The elongated vaporization heater of Example 3 was sealingly disposed over the elongated container 30 which had received Alq in powder form in an amount approximately equivalent to a fill-level b, but substantially distributed towards one end wall of the container.

The vaporization heater was heated in a manner described in Comparative Example 1 to effect vaporization of uppermost portions of the nonuniformly distributed solid Alq material.

Relative uniformity of a normalized deposition rate is shown in FIG. 17 as a trace 4 in solid outline.

### Example 5

The elongated vaporization heater of Example 3 was sealingly disposed over the elongated container 30 which had received Alq in powder form as a uniformly distributed charge to a fill-level 0.125xb of approximately 1.6 mm.

The vaporization heater was heated in a manner described in Comparative Example 1 to effect vaporization of uppermost portions of the nonuniformly distributed solid Alq material.

Relative uniformity of a normalized deposition rate was substantially identical to the normalized deposition rates of trace 3 of FIG. 16, and of trace 4 of FIG. 17.

Turning to FIG. 16, a graph shows a normalized deposition rate as determined from deposition rates measured by each of the eight crystal mass-sensors 501 to 508 of the sensor array SA of FIG. 15 during vaporization of Alq. The points forming the traces 1 (dotted), 2 (dashed), and 3 (solid) represent the positions of the sensors 501 to 508 with respect to the elongated direction of the vapor deposition source. The horizontal axis of the graph reflects the sensor spacing or sensor position, which is given in millimeters (mm). The length dimension L over which the apertures extend along the elongated direction of the vaporization heater 40 is indicated.

Comparative Example 1 is shown as a trace 1 in dotted outline. The vapor efflux from this single-slit vapor efflux aperture is relatively nonuniform along the elongated direction of the slit. Such relative nonuniformity may be caused by a deviation of planarity of opposing edges of the slit-aperture upon heating the vaporization heater to effect vaporization of the Alq material.

Comparative Example 2 is shown as a trace 2 in dashed outline. Relative uniformity of the normalized deposition rate is improved over a central portion of the aperture arrangement when compared to the single-slit results of Comparative Example 1. This improved relative uniformity may be related to an improved mechanical integrity of the plurality of apertures, which are spaced from one another by 1.0 mm. Since the aperture spacing is a metal bridge, opposing edges of the 10 mm long apertures are likely to retain planarity.

Example 3 is shown as a trace 3 in solid outline. Relative uniformity of the normalized deposition rate is substantially improved over an extended portion of the length dimension L over which the plurality of apertures are formed in this vaporization heater, and wherein the apertures having progressively decreasing aperture spacing towards end portions of the aperture arrangement. In fact, the uniformity over the central 300 mm portion, the region that the source was designed for, is extremely good. The non-uniformity is less than about 5% over this region and demonstrates that a high level of uniformity can be achieved with an appropriately designed vaporization heater.

Turning to FIG. 17, the graph shows the normalized deposition rate of Example 4 as a trace 4, depicted in solid outline. Relative uniformity of the normalized deposition rate is substantially identical to the uniformity of Example 3 of FIG. 16 even though the Alq powder was received nonuniformly in the elongated container 30. Thus, the findings of Example 4 appear to support the belief that a vapor cloud VC is formed uniformly throughout the space between the baffle member 50 and the container 30 wherein formation of the vapor cloud is caused by a vapor pressure Pᵥ of vaporized Alq which is significantly higher than a reduced pressure P_{c} in the chamber C.

Other features of the invention are included below.

The elongated thermal physical vapor deposition source wherein the solid organic material received in the container includes doped or undoped organic hole-injecting material, doped or undoped organic hole-transporting material, doped or undoped organic light-emitting material, or doped or undoped organic electron-transporting material.

The elongated thermal physical vapor deposition source wherein the solid organic material received in the container includes powder, flakes, particulates, or one or more solid pellets of such organic material.

The elongated thermal physical vapor deposition source wherein the solid organic material received in the container includes one or more organic host materials.

The elongated thermal physical vapor deposition source wherein the solid organic material received in the container includes one or more organic dopant materials.

The elongated thermal physical vapor deposition source wherein the solid organic material received in the container includes one or more organic host materials and one or more organic dopant materials.

The elongated thermal physical vapor deposition source wherein the means for providing relative motion between the elongated vapor deposition source and the structure includes a lead screw adapted either to move the source with respect to a fixedly disposed structure, or to move the structure with respect to a fixedly disposed source.

The elongated thermal physical vapor deposition source wherein an exterior or an interior surface of the side walls and the bottom wall of the container are coated at least in part with a heat-reflective layer.

An elongated thermal physical vapor deposition source for vaporizing solid organic materials and applying a vaporized organic material as a layer onto a surface of a structure in a chamber at reduced pressure in forming a part of an organic light-emitting device (OLED), comprising:
a) an elongated bias heater defined by side walls and a bottom wall, the side walls having a height dimension H_{B};
b) an elongated electrically insulative container disposed in the bias heater, the container receiving solid organic material which can be vaporized, the container defined by side walls having common upper side wall surfaces, and the container side walls having a height dimension H_{c} which is greater than the height dimension H_{B} of the bias heater side walls;
c) an elongated vaporization heater sealingly disposed on the common upper side wall surfaces of the container, the vaporization heater defining a plurality of vapor efflux apertures extending into the container and arranged along an elongated direction of the vaporization heater, such apertures having varying size or varying spacing between adjacent apertures, or combinations thereof, wherein such varying aperture size or varying aperture spacing is selected to provide a substantially improved uniformity of vapor efflux of vaporized organic material along the elongated direction of the vapor deposition source when the vaporization heater is heated to vaporize a portion of the solid organic material in the container;
d) an elongated electrically conductive baffle member electrically connected to the vaporization heater, the baffle member being spaced from the vaporization heater in a direction towards the container, the baffle member substantially providing a line-of-sight covering of the plurality of vapor efflux apertures to prevent direct access of vaporized organic materials to the apertures, and to prevent particulate organic materials from passing through the apertures;
e) means for applying an electrical potential to the bias heater to cause bias heat to be applied to the solid organic material in the container, the bias heat providing a bias temperature which is insufficient to cause the solid organic material to vaporize;
f) means for applying an electrical potential to the vaporization heater to cause vaporization heat to be applied to uppermost portions of the solid organic material in the container causing such uppermost portions to vaporize so that vaporized organic material is projected off the side walls of the container and lower surfaces of the vaporization heater and an upper surface of the baffle member through the plurality of vapor efflux apertures onto the structure to provide an organic layer on the structure; and
g) means for providing relative motion between the elongated vapor deposition source and the structure in directions substantially perpendicular to the elongated direction of the source to provide a substantially uniform organic layer on the structure.

The elongated thermal physical vapor deposition source wherein the plurality of vapor efflux apertures defined in the vaporization heater are arranged along a center line, all apertures being of one and the same selected size, and the spacing between adjacent apertures decreasing progressively towards end portions along the center line from a selected even spacing in a central portion along the center line of apertures.

The elongated thermal physical vapor deposition source wherein the plurality of vapor efflux apertures defined in the vaporization heater are arranged along a center line, the spacing between adjacent apertures having one and the same selected value, and the size of the apertures increasing progressively towards end portions along the center line from a selected even aperture size in a central portion along the center line of apertures.

The elongated thermal physical vapor deposition source wherein the plurality of vapor efflux apertures defined in the vaporization heater are arranged along a center line, the spacing between adjacent apertures decreasing progressively towards end portions along the center line from a selected even spacing in a central portion along the center line of apertures, and the size of apertures increasing progressively towards end portions along the center line from a selected even aperture size in a central portion along the center line of apertures.

The elongated thermal physical vapor deposition source wherein the plurality of vapor efflux apertures defined in the vaporization heater are arranged in a pattern with respect to a pattern center line, the pattern including parallel rows of apertures towards end portions of the pattern center line, and the pattern including a sequence of single apertures in a central portion of the pattern center line.

The elongated thermal physical vapor deposition source wherein the plurality of vapor efflux apertures defined in the vaporization heater include apertures having a polygonal outline, a circular outline, an ellipsoidal outline, an oval outline, or a combination of such aperture outlines.

The elongated thermal physical vapor deposition source wherein the solid organic material received in the container includes doped or undoped organic hole-injecting material, doped or undoped organic hole-transporting material, doped or undoped organic light-emitting material, or doped or undoped organic electron-transporting material.

The elongated thermal physical vapor deposition source wherein the solid organic material received in the container includes powder, flakes, particulates, or one or more solid pellets of such organic material.

The elongated thermal physical vapor deposition source wherein the solid organic material received in the container includes one or more organic host materials.

The elongated thermal physical vapor deposition source wherein the solid organic material received in the container includes one or more organic dopant materials.

The elongated thermal physical vapor deposition source wherein the solid organic material received in the container includes one or more organic host materials and one or more organic dopant materials.

The elongated thermal physical vapor deposition source wherein the means for providing relative motion between the elongated vapor deposition source and the structure includes a lead screw adapted either to move the source with respect to a fixedly disposed structure, or to move the structure with respect to a fixedly disposed source.

In an elongated thermal physical vapor deposition source including an elongated electrically insulative container for receiving solid organic material which can be vaporized, and means for heating and vaporizing at least a portion of the solid organic material and applying the vaporized organic material as a layer onto a surface of a structure in a chamber at reduced pressure in forming a part of an organic light-emitting device (OLED), the improvement comprising:
a) an elongated vaporization heater sealingly disposed on common upper side wall surfaces of the container, the vaporization heater defining a plurality of vapor efflux apertures extending into the container and arranged along an elongated direction of the vaporization heater, such apertures having varying size or varying spacing between adjacent apertures apertures, or combinations thereof, wherein such varying aperture size or varying aperture spacing is selected to provide a substantially improved uniformity of vapor efflux of vaporized organic material along the elongated direction of the vapor deposition source when the vaporization heater is heated to vaporize a portion of the solid organic material in the container; and
b) means for providing relative motion between the elongated vapor deposition source and the structure in directions substantially perpendicular to the elongated direction of the source to provide a substantially uniform organic layer on the structure.

The elongated thermal physical vapor deposition source wherein the plurality of vapor efflux apertures defined in the vaporization heater are arranged along a center line, all apertures being of one and the same selected size, and the spacing between adjacent apertures decreasing progressively towards end portions along the center line from a selected even spacing in a central portion along the center line of apertures.

The elongated thermal physical vapor deposition source wherein the plurality of vapor efflux apertures defined in the vaporization heater are arranged along a center line, the spacing between adjacent apertures having one and the same selected value, and the size of the apertures increasing progressively towards end portions along the center line from a selected even aperture size in a central portion along the center line of apertures.

The elongated thermal physical vapor deposition source wherein the plurality of vapor efflux apertures defined in the vaporization heater are arranged along a center line, the spacing between adjacent apertures decreasing progressively towards end portions along the center line from a selected even spacing in a central portion along the center line of apertures, and the size of apertures increasing progressively towards end portions along the center line from a selected even aperture size in a central portion along the center line of apertures.

The elongated thermal physical vapor deposition source of wherein the plurality of vapor efflux apertures defined in the vaporization heater are arranged in a pattern with respect to a pattern center line, the pattern including parallel rows of apertures towards end portions of the pattern center line, and the pattern including a sequence of single apertures in a central portion of the pattern center line.

The elongated thermal physical vapor deposition source wherein the plurality of vapor efflux apertures defined in the vaporization heater include apertures having a polygonal outline, a circular outline, an ellipsoidal outline, an oval outline, or a combination of such aperture outlines.

The elongated thermal physical vapor deposition source wherein the solid organic material received in the container includes doped or undoped organic hole-injecting material, doped or undoped organic hole-transporting material, doped or undoped organic light-emitting material, or doped or undoped organic electron-transporting material.

The elongated thermal physical vapor deposition source wherein the solid organic material received in the container includes powder, flakes, particulates, or one or more solid pellets of such organic material.

The elongated thermal physical vapor deposition source wherein the solid organic material received in the container includes one or more organic host materials.

The elongated thermal physical vapor deposition source wherein the solid organic material received in the container includes one or more organic dopant materials.

The elongated thermal physical vapor deposition source of wherein the solid organic material received in the container includes one or more organic host materials and one or more organic dopant materials.

The elongated thermal physical vapor deposition source wherein the means for providing relative motion between the elongated vapor deposition source and the structure includes a lead screw adapted either to move the source with respect to a fixedly disposed structure, or to move the structure with respect to a fixedly disposed source.

## Claims

1. A method for coating a structure by vaporizing organic material disposed in an elongated container having walls, comprising the steps of:
a) providing a cover on the container having apertures;
b) providing a baffle between the cover and the organic material to prevent direct access of vaporized organic material from passing through the apertures without first engaging the walls of the container; and
c) forming the apertures to have varying size or varying spacing between adjacent apertures, or combinations thereof, wherein such varying aperture size or varying aperture spacing is selected to provide a substantially improved uniformity of vapor efflux of vaporized organic material along the elongated direction of a vapor deposition source so that the vaporized organic material is prevented by the baffle from direct line-of-sight access to the apertures to prevent particulate organic material from passing through the apertures.

2. The method of claim 1 further including providing relative movement between the structure and the container.

3. The method of claim 1 wherein the apertures are arranged along a center line, all apertures being of one and the same selected size, and the spacing between adjacent apertures decreasing progressively towards end portions along the center line from a selected even spacing in a central portion along the center line of apertures.

4. The method of claim 1 wherein the apertures are arranged along a center line, the spacing between adjacent apertures having one and the same selected value, and the size of the apertures increasing progressively towards end portions along the center line from a selected even aperture size in a central portion along the center line of apertures.

5. An elongated thermal physical vapor deposition source for vaporizing solid organic materials and applying a vaporized organic material as a layer onto a surface of a structure in a chamber at reduced pressure in forming a part of an organic light-emitting device (OLED), comprising:
a) an elongated electrically insulative container for receiving solid organic material which can be vaporized, the container defined by side walls having common upper side wall surfaces, and a bottom wall;
b) an elongated vaporization heater sealingly disposed on the common upper side wall surfaces of the container, the vaporization heater defining a plurality of vapor efflux apertures extending into the container and arranged along an elongated direction of the vaporization heater, such apertures having varying size or varying spacing between adjacent apertures, or combinations thereof, wherein such varying aperture size or varying aperture spacing is selected to provide a substantially improved uniformity of vapor efflux of vaporized organic material along the elongated direction of the vapor deposition source when the vaporization heater is heated to vaporize a portion of the solid organic material in the container;
c) an elongated electrically conductive baffle member electrically connected to the vaporization heater, the baffle member being spaced from the vaporization heater in a direction towards the container, the baffle member substantially providing a line-of-sight covering of the plurality of vapor efflux apertures to prevent direct access of vaporized organic materials to the apertures, and to prevent particulate organic materials from passing through the apertures;
d) means for applying an electrical potential to the vaporization heater to cause vaporization heat to be applied to uppermost portions of the solid organic material in the container causing such uppermost portions to vaporize so that vaporized organic material is projected off the side walls of the container and lower surfaces of the vaporization heater and an upper surface of the baffle member through the plurality of vapor efflux apertures onto the structure to provide an organic layer on the structure; and
e) means for providing relative motion between the elongated vapor deposition source and the structure in directions substantially perpendicular to the elongated direction of the source to provide a substantially uniform organic layer on the structure.

6. The elongated thermal physical vapor deposition source of claim 5 wherein the plurality of vapor efflux apertures defined in the vaporization heater are arranged along a center line, all apertures being of one and the same selected size, and the spacing between adjacent apertures decreasing progressively towards end portions along the center line from a selected even spacing in a central portion along the center line of apertures.

7. The elongated thermal physical vapor deposition source of claim 5 wherein the plurality of vapor efflux apertures defined in the vaporization heater are arranged along a center line, the spacing between adjacent apertures having one and the same selected value, and the size of the apertures increasing progressively towards end portions along the center line from a selected even aperture size in a central portion along the center line of apertures.

8. The elongated thermal physical vapor deposition source of claim 5 wherein the plurality of vapor efflux apertures defined in the vaporization heater are arranged along a center line, the spacing between adjacent apertures decreasing progressively towards end portions along the center line from a selected even spacing in a central portion along the center line of apertures, and the size of apertures increasing progressively towards end portions along the center line from a selected even aperture size in a central portion along the center line of apertures.

9. The elongated thermal physical vapor deposition source of claim 5 wherein the plurality of vapor efflux apertures defined in the vaporization heater are arranged in a pattern with respect to a pattern center line, the pattern including parallel rows of apertures towards end portions of the pattern center line, and the pattern including a sequence of single apertures in a central portion of the pattern center line.

10. The elongated thermal physical vapor deposition source of claim 5 wherein the plurality of vapor efflux apertures defined in the vaporization heater include apertures having a polygonal outline, a circular outline, an ellipsoidal outline, an oval outline, or a combination of such aperture outlines.
